# EUROPÄISCHE PATENTSCHRIFT

(11) **EP 2 641 995 B1**
(45) Veröffentlichungstag und Bekanntmachung des Hinweises auf die Patenterteilung: **04.07.2018**
(21) Anmeldenummer: 12199757.1
(22) Anmeldetag: 28.12.2012
(51) Int. Cl.: C23C 16/04, C23C 16/52, H01J 37/32

(54) **Absaugventil in einer Plasmabeschichtungsvorrichtung**
Purge valve in a plasma deposition apparatus
Soupape d'aspiration dans un dispositif de revêtement par plasma

(30) Priorität: 23.03.2012 DE 102012204689
(43) Veröffentlichungstag der Anmeldung: 25.09.2013
(73) Patentinhaber: Krones AG, 93073 Neutraubling (DE)
(72) Erfinder: Krüger, Jochen, 93073 Neutraubling (DE); Kraus, Andreas, 93073 Neutraubling (DE)
(74) Vertreter: Grünecker Patent- und Rechtsanwälte PartG mbB

(56) Entgegenhaltungen:
- EP-A1- 1 602 748
- DE-A1-102010 000 940
- US-A1- 2002 108 933
- US-A1- 2010 298 738
- MONTI G ET AL: "Metal foams for electromagnetic shielding: a plasma model", 3RD EUROPEAN CONFERENCE ON ANTENNAS AND PROPAGATION - EUCAP 2009, 23. - 27. MÄRZ 2009, BERLIN [DE], 23. März 2009 (2009-03-23), Seiten 2123-2126, XP031470211, IEEE, PISCATAWAY, NJ [US] ISBN: 978-1-4244-4753-4

## Beschreibung

### Stand der Technik

Zur Verminderung der Durchlässigkeit von Behälter-/Hohlkörperwänden, z.B. in Bezug auf unerwünschte Stoffe, ist es vorteilhaft, diese mit einer Barriereschicht zu versehen, beispielsweise durch plasmaunterstützte chemische Gasphasenabscheidung / Plasma Enhanced Chemical Vapor Depositon (PECVD), wie z.B. in der EP0881197A2 beschrieben. Weitere Beispiele für bekannte plasmaunterstützte Beschichtungsprozesse von Hohlkörpern sind in der EP1602748A1 und der US2010/0298738 beschrieben. Darüber hinaus beschreibt Monti G. et al. in "Metal foams for electromagnetic shielding: a plasma model", 3RD EUROPEAN CONFE-RENCE ON ANTENNAS AND PROPAGATION - EUCAP 2009, 23. - 27. MÄRZ 2009, BERLIN [DE], IEEE, PISCATAWAY, NJ [US], (20090323), ISBN 978-1-4244-4753-4, Seiten 2123 - 2126) elektromagnetische Abschirmungseigenschaften metallischer Schäume, welche sich unter Umständen als mögliche Abschirmungsmaterialien bei Plasmabehandlungsprozessen eignen können.

Solche Barriereschichten werden z.B. benötigt, um die Transmissionsraten von Gasen durch die Kunststoffwand eines Behälters zu reduzieren. Auf diese Weise kann beispielsweise der Verlust von CO₂ aus dem eingefüllten Produkt oder der Eintrag von Sauerstoff in das Produkt minimiert werden. Auch kann das Produkt so vor Stoffen geschützt werden, die aus dem Behältermaterial kommen und das Produkt farblich oder geschmacklich verändern können.

Zur Beschichtung von Behältnissen mittels Plasmabehandlung, beispielsweise der Plasmainnenbeschichtung von Kunststoffflaschen, kann unter anderem ein sogenanntes Hochfrequenzplasma in sogenannten Niederdruck-Anlagen eingesetzt werden.

Dabei wird zunächst das Innere des Behälters auf einen Druck im Bereich von 1-10 Pa evakuiert. In den Bereich der zu beschichtenden Oberfläche, z.B. dem Behälterinneren, wird dann über eine Gaslanze ein Prozessgas eingeleitet, aus dem die Schicht gebildet wird, der sogenannte "Precursor", wodurch sich der Druck im Inneren des Behälters auf 10 - 30 Pa oder mehr erhöhen kann.

Dieses Gas oder Gasgemisch kann dann mit Hilfe elektromagnetischer Strahlung, z.B. Mikrowelle oder Hochfrequenz, z.B. mit 13,56 MHz, oder anderer elektrischer Felder teilweise oder vollständig in einen Plasmazustand versetzt und dabei in seine Bestandteile zerlegt werden.

Dabei koppelt zum Beispiel eine Hochfrequenz, die von einer flächigen Elektrode außerhalb des Behälters eingestrahlt wird, an eine elektrisch leitende Gaslanze an und zündet bei günstigen Druckbedingungen im Behälter zwischen 10 und 30 Pa ein Plasma im Inneren des zu beschichtenden Behälters.

Teile des über geeignete Bohrungen in der Gaslanze dem Behälterinneren zugeführten Prozessgases reagieren plasmaunterstützt in der Gasphase oder an der Oberfläche des zu beschichtenden Substrates, z.B. der Innenwand einer Kunststoffflasche, und kondensieren an dieser Oberfläche zu einer geschlossenen Schicht.

Um zu verhindern, dass außerhalb der Flaschen ein Plasma zündet, wird dieser Bereich auf einem höheren Druck, beispielsweise 3000 bis 4000 Pa, gehalten als er im Behälter herrscht. Zu diesem Zweck kann der Behälter an ein Ventil gepresst und über dieses das Behälterinnere auf den Prozessdruck von 1 - 30 Pa abgesaugt werden.

Ein Problem, das sich in der Praxis herausstellt ist, dass das Plasma nicht nur im Behälter, sondern auch unerwünschterweise im Absaugventil selbst brennen kann. Dieses Plasma verbraucht einen undefinierten und undefinierbaren Anteil an Energie, der dann nicht mehr im Behälter zur Verfügung steht, um die Prozessgase zu zersetzen. Dabei ist es nicht einfach, diesen Energieverlust beispielsweise durch eine höhere Hochfrequenzleistung zu kompensieren, da dies zu höheren Spannungen an den Elektroden führen kann. Diese höheren Spannungen können wiederum das Auftreten von Plasmaentladungen außerhalb des Behälters begünstigen, wodurch die im Behälter selbst zur Verfügung stehende elektrische Leistung noch weiter vermindert wird.

Ein weiteres Problem sind die Temperaturen und die reaktiven Gase, die durch das Plasma im Ventil entstehen. Sie erschweren den Prozess weiterhin, da die Ventile aktiv gekühlt werden müssen, um sie vor Beschädigung zu schützen. Ferner werden Dichtungsmaterialien im Ventil durch die reaktiven Gase in Mitleidenschaft gezogen und bedürfen einer häufigen Erneuerung.

Werden die Ventile aus Kunststoff gefertigt, so stellen sie prinzipiell von den Bedingungen her eine geometrische Verlängerung der Flaschenmündung dar. Bei Einkopplung von Hochfrequenz zündet allerdings dann dort ein Plasma genauso wie im Behälter selbst. Baut man das Ventil aus Metall und erdet die einzelnen Komponenten, so kann sich im Inneren dennoch ein Plasma ausbilden, da man auf diese Weise eine Hohlkathode erzeugen kann. Derartige Hohlkathodenplasmen weisen zudem eine besonders intensive Plasmadichte auf, was die Ventilkomponenten besonders stark aufheizen und so beschädigen kann.

### Aufgabe

Es ist somit Aufgabe der Erfindung, eine Vorrichtung zur Beschichtung von Behältern mittels Plasmabehandlung, beispielsweise der Beschichtung von Kunststoffflaschen, zu verbessern, insbesondere hinsichtlich der Minimierung von unerwünschtem Plasmazünden und/oder Plasmabrennen im Bereich der Behälteröffnung.

### Lösung

Dies wird erfindungsgemäß durch eine Vorrichtung nach Anspruch 1 und durch ein Verfahren nach Anspruch 10 erreicht. Vorteilhafte Ausführungsformen und Weiterbildungen sind Gegenstand der Unteransprüche.

Eine erfindungsgemäße Vorrichtung zur Beschichtung eines Behälters, beispielsweise einer Kunststoffflasche, mittels Plasmabehandlung, beinhaltet wenigstens eine Gaslanze zum Zuführen von Prozessgas in den Behälter und wenigstens ein Absaugventil zum Absaugen von Luft bzw. Gas aus dem Behälterinneren.

Das Absaugventil weist dabei wenigstens eine Aussparung, z.B. mittig angeordnet, zur Aufnahme oder Einfuhr der wenigstens einen Gaslanze in den Behälter auf, und das Absaugventil weist wenigstens ein geerdetes gasdurchlässiges elektrisches Abschirmungselement auf, wobei das wenigstens eine geerdete, gasdurchlässige elektrische Abschirmungselement das Zünden und/oder Brennen von Plasma im Absaugventil nahezu vollständig verhindert und/oder unterdrückt. Die Vermeidung bzw. Minimierung von Plasmazündungen und/oder Plasmabrennen im Absaugventil hat unter anderem den Vorteil, dass das Absaugventil thermisch weniger belastet wird, z.B. auf eine aktive Kühlung verzichtet werden kann, und somit eine längere Lebensdauer des Absaugventils erreicht werden kann. Darüber hinaus hat die Minimierung von unerwünschten Plasmazündungen und/oder Plasmabrennvorgängen im Absaugventil bzw. außerhalb des zu beschichtenden Behälterbereichs, den Vorteil dass ein Energieverlust für das zur Beschichtung eingesetzte Plasma reduziert werden kann.

Das elektrische Abschirmungselement um die wenigstens eine Aussparung zur Aufnahme oder Einfuhr der wenigstens einen Gaslanze, kann gasdurchlässige Hohlraumstrukturen aufweisen. Bevorzugterweise können diese gasdurchlässige Hohlraumstrukturen mittlere Durchmesser aufweisen die gleich oder kleiner der Debye-Länge des bei der Beschichtung erzeugten Plasmas sind, um eine effektive elektrische Abschirmungswirkung zur Minimierung von Plasmazünd- und Brennvorgängen im Absaugventil erreichen zu können.

Das elektrische Abschirmungselement kann beispielsweise eine Vielzahl unterschiedlicher Strukturen aufweisen.

Insbesondere kann z.B. ein nicht zur Erfindung gehörendes elektrische Abschirmungselement eine gasdurchlässige offenporig poröse Struktur aufweisen, mit Poren deren mittlere Porendurchmesser z.B. zwischen 0.01 bis 6 mm, bevorzugt bei 3 bis 4 mm liegen.

Es ist dabei möglich, dass besagte gasdurchlässige Hohlraumstruktur, bzw. besagte gasdurchlässige offenporig poröse Struktur des elektrischen Abschirmungselementes aus metallischem Schaum, beispielsweise Aluminiumschaum, oder elektrisch leitendem keramischen Schaum, beispielsweise Al₂O₃/TiN oder elektrisch leitfähiger Verbundkeramik mit Kohlenstofffasern, oder aus elektrisch leitfähig ausgestattetem Kunststoff- oder Polymerschaum, oder aus einer Kombination genannter Schäume bestehen kann.

Ein nicht zur Erfindung gehöriges elektrisches Abschirmungselement um die wenigstens eine Aussparung zur Aufnahme oder Einfuhr der wenigstens einen Gaslanze, kann ebenso wenigstens eine netzartige Gitterstruktur aufweisen mit mittleren Netzmaschendurchmessern von z.B. zwischen 0.01 bis 6 mm, bevorzugt 0.2 bis 0.5 mm, liegen. Dabei ist z.B. auch denkbar, dass das Absaugventil eine Vielzahl elektrischer Abschirmungselemente mit netzartiger Gitterstruktur aufweisen kann, die in mehreren Lagen mit Abständen zwischen 0.01 bis 6 mm, bevorzugt 0.5 bis 1 mm, im Absaugventil angeordnet sein können, um beispielsweise ein Zünden und/oder Etablieren eines Plasmas zwischen den Lagen unterbinden zu können.

Ferner ist denkbar, dass ein nicht zur Erfindung gehöriges elektrisches Abschirmungselement um die wenigstens eine Aussparung zur Aufnahme oder Einfuhr der wenigstens einen Gaslanze aus konzentrisch angeordneten Wänden mit radialen Zwischentrennwänden besteht, mit mittleren Wandabständen der konzentrisch angeordneten Wänden, die z.B. zwischen 0.01 bis 6 mm, bevorzugt 3 bis 4 mm und mittleren Abständen der radialen Zwischentrennwänden, z.B. zwischen 0.01 bis 6 mm, bevorzugt 3 bis 4 mm liegen.

Das elektrische Abschirmungselement um die wenigstens eine Aussparung zur Aufnahme oder Einfuhr der wenigstens einen Gaslanze, ist erfindungsgemäß als Wabenstruktur ausgebildet , mit mittleren Wabendurchmessern der Wabenröhren, die z.B. zwischen 0.01 bis 6 mm, bevorzugt 3 bis 4 mm liegen.

Die mittlere Länge der Wabenröhren ist dabei größer als der mittlere Wabendurchmesser der Wabenröhren, und z.B. kann die mittlere Länge der Wabenröhren um einen Faktor von 4.0, 6.0, 10.0 oder mehr, bevorzugt 5 bis 10 den mittleren Wabendurchmesser der Wabenröhren übertreffen. Dies hat unter anderem den Vorteil, dass das Risiko des Durchschlagens des Plasmas entlang der Längsachse des Absaugventils minimiert werden kann.

Die Formen der Querschnitte der Wabenröhren können regelmäßige Polygonenform, z.B. Dreieck, Quadrat, Pentagon, Hexagon, konvexe und/oder nichtkonvexe Innenwandform, sternförmige Polygonenform, runde Formen, z.B. Kreisform, Ellipsenform, oder eine Kombination genannter Formen sein. Hier erfindungsgemäß beansprucht sind jedoch hexagonale Querschnitte, um ein optimiertes Verhältnis von Wabenstrukturmaterial, Wabenstrukturvolumen und Wabenstrukturstabilität erreichen zu können.

Ferner sind als elektrisches Abschirmungselement auch Metallplatten denkbar, die eine Vielzahl von Bohrungen, mit mittleren Bohrungsdurchmessern von 0.01 bis 6 mm, bevorzugt 3 bis 4 mm , aufweisen können. Die Länge der Bohrungen kann ein Vielfaches der mittleren Bohrungsdurchmesser sein, bevorzugt um einen Faktor 5 bis 10, den mittleren Bohrungsdurchmesser übertreffen.

Das elektrische Abschirmungselement kann dabei aus Metall, z.B. Aluminium, elektrisch leitfähiger Keramik, z.B. Al₂O₃/TiN, elektrisch leitfähiger Verbundkeramik mit Kohlenstofffasern, elektrisch leitfähig ausgestattetem Kunststoff, oder aus einer Kombination genannter Materialen bestehen.

Der Strömungswiderstand des Absaugventils beim Absaugen von Luft bzw. Gas aus dem Behälter hängt in erster Linie vom offenen Querschnitt des Absaugventils, dem Reibungswiderstand an der Innenwandung des Absaugentils und der Luftführung im Ventil ab. Die Geschwindigkeit, mit der das Behälterinnere auf den gewünschten Prozessdruck abgesaugt werden kann, ist vor allem durch den Öffnungsquerschnitt des Behälters selbst begrenzt.

Bevorzugterweise kann der Öffnungsquerschnitt des Absaugventils daher mindestens genau so groß sein wie der Öffnungsquerschnitt des Behälters. Bevorzugterweise kann auch der Strömungswiderstand des Absaugventils beim Absaugen gleich oder kleiner ist als der Strömungswiderstand durch die Behältermündung bzw. Behälteröffnung sein.

Dies hat den Vorteil dass das Behälterinnere hinreichend schnell, z.B. in weniger als 500 ms, auf einen gewünschten Prozessdruck, z.B. zwischen 1 bis 30 Pa evakuiert werden kann, um die Behälter in der Geschwindigkeit zu behandeln bzw. zu beschichten zu können, in der sie die den Produktionsprozess, beispielsweise auf Förderbändern, oder Halteklammern eines Karussells durchlaufen.

Das elektrische Abschirmungselement kann einteilig oder mehrteilig ausgebildet sein und in seiner Höhe mindestens 10 %, 20%, 30% oder 60% oder mehr der Höhe, des Absaugventils einnehmen.

Das Absaugventil kann aber auch eine Vielzahl von elektrischen Abschirmungselementen aufweisen und in der Summe der Höhen der einzelnen elektrischen Abschirmungselemente mindestens 10 %, 20%, 30% oder 60% oder mehr der Höhe, des Absaugventils einnehmen. Das elektrische Abschirmungselement kann also z.B. aus einer Kombination von Wabenstruktur, offenporig porösem Schaum, oder Gitter bestehen, wobei der vertikale Abstand zwischen den verschiedenen Teilen, kleiner als 1, 2 mm, bevorzugterweise kleiner als 0.5 mm, sein kann.

In dem erfindungsgemäßen Verfahren zur Beschichtung eines Behälters, beispielsweise einer Kunststoffflasche, mittels Plasmabehandlung wird also eine Gaslanze durch eine Aussparung eines auf der Behälteröffnung sitzenden Absaugventils in das Innere des Behälters eingeführt. Über das Absaugventil wird das Behälterinnere auf Prozessdruck, z.B. 1 bis 30 Pa, evakuiert. Im Behalterinneren wird ein über die Gaslanze zugeführtes Prozessgas teilweise oder vollständig in ein Plasma umgesetzt und über plasmaunterstützte Gasphasenabscheidung das Innere des Behälters beschichtet, z.B. mit einer Gasbarriereschicht. Dabei wird ein sich im Absaugventil befindliches elektrisches Abschirmelement ein Zünden und/oder Brennen von Plasma im Absaugventil bzw. in einem Bereich, der nicht beschichtet werden soll, nahezu vollständig verhindern und/oder unterdrücken.

Beigefügte Figuren stellen beispielhaft dar:
**Fig.1****:** Behälter mit Gaslanze und Absaugventil.
**Fig.2****:** Absaugventil.
**Fig.3****:** Absaugventil.
**Fig.4****:** Wabenstruktur.
**Fig.5****:** Beispielhafte Querschnitte für elektrische Abschirmelemente.

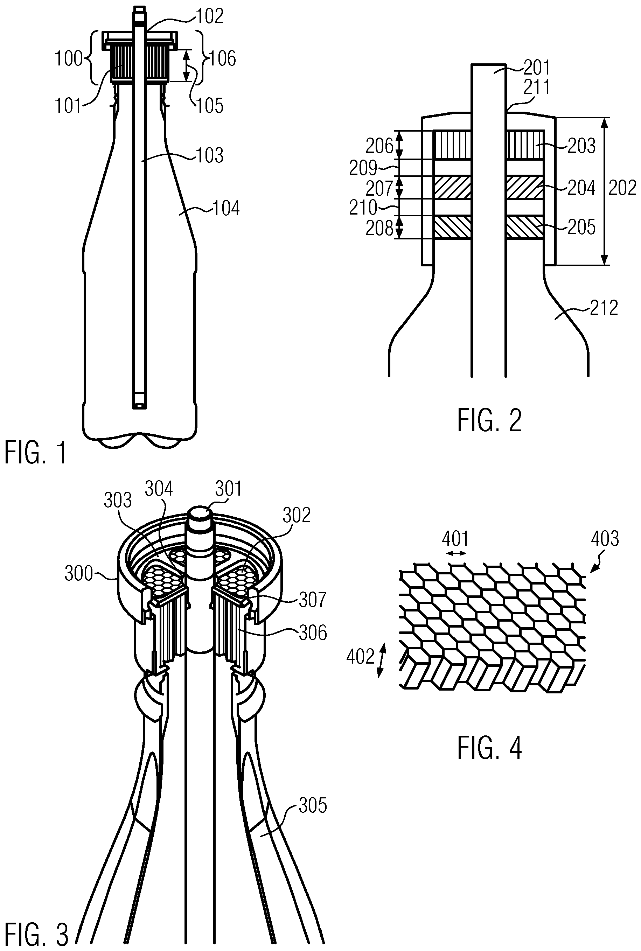

In **Fig. 1** ist beispielhaft ein Behälter 104 mit einem Absaugventil 100 dargestellt. Eine Gaslanze 103 kann hier über eine Aussparung 102 im Absaugventil 100 in den Behälter eingeführt werden. Das Absaugventil 100 kann dabei über ein elektrisches Abschirmelement 101 verfügen, welches eine Höhe 105 aufweist, die sich z.B. über nahezu die gesamte Höhe 106 des Absaugventils 100 erstrecken kann.

Die **Fig. 2** zeigt beispielhaft die Mündung eines Behälters 212 auf dem ein Absaugventil 200 sitzt. Eine Gaslanze 201 kann durch eine Aussparung 211 des Absaugventils 200 in den Behälter 212 eingeführt werden. Das Absaugventil 200 kann dabei eine Vielzahl von elektrischen Abschirmungselementen 203, 204, 205 aufweisen, die verschiedene Höhen 206, 207 und 208 und Abstände 209, 210, z.B. Abstände 209, 210 zwischen 0.01 bis 6 mm, bevorzugt 0.5-1 mm, voneinander haben können. Die Summe der einzelnen Höhen 206, 207 und 208 der elektrischen Abschirmungselemente 203, 204, 205 können dabei mindestens 10 %, 20%, 30% oder 60% oder mehr der Höhe 202 des Absaugventils 200 einnehmen.

Zudem können die elektrischen Abschirmungselemente 203, 204, 205 in Material und Aufbau verschieden voneinander sein, z.B. kann das elektrische Abschirmelement 205 aus offenporig porösem Metallschaum, das elektrische Abschirmelement 204 aus einer Wabenstruktur und das elektrische Abschirmelement 203 aus einer Gitternetzstruktur bestehen.

Die **Fig.3** zeigt beispielhaft die Mündung eines Behälters 305 auf dem ein Absaugventil 300 sitzt. Eine Gaslanze 301 kann durch eine Aussparung 304 des Absaugventils 300 in den Behälter 305 eingeführt werden. Die Gaslanze 301 kann zusätzlich durch eine Halterung 303 fixiert werden. Das Absaugventil 300 kann über ein elektrisches Abschirmelement 302 aus einer Wabenstruktur verfügen, wobei wie die mittlere Länge der Wabenröhren 306 um einen Faktor von 1.5, 2.0, 4.0, 6.0, 10.0 oder mehr, bevorzugt 5 bis 10, größer sein kann als der Wabendurchmesser der Wabenröhren 306. Der Wabendurchmesser 307 der Wabenröhren 306 kann dabei zwischen 0.01 bis 6 mm, bevorzugt bei 3 bis 4 mm liegen. Siehe hierzu auch **Fig. 4****,** wo beispielhaft der Wabendurchmesser 401 und die Länge 402 einer Wabenröhre in einer Wabenstruktur 403 dargestellt ist.

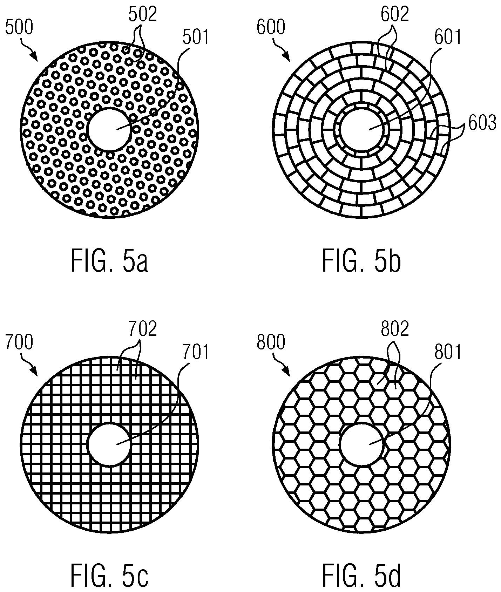

Die **Figuren 5a, 5b, 5c, 5d** stellen beispielhaft verschiedene Querschnittsformen verschiedener beispielhafter elektrischer Abschirmelemente dar.

In **Fig. 5a** weist das elektrische Abschirmelement 500 z.B. eine offenporig poröse Struktur um die Aussparung 501 herum auf, wobei die Poren 502 mittlere Porendurchmesser zwischen 0.01 bis 6 mm, bevorzugt von 3 bis 4 mm aufweisen können.

In **Fig. 5b** weist das elektrische Abschirmelement 600 z.B. eine Struktur aus konzentrischen Wänden 602 mit radialen Zwischentrennwänden 603 um die Aussparung 601 herum auf, wobei der mittlere Abstand zwischen den konzentrischen Wänden 602 und den radialen Zwischentrennwänden 603 jeweils zwischen 0.01 bis 6 mm, bevorzugt bei 3 bis 4 mm liegen kann.

In **Fig. 5c** weist das elektrische Abschirmelement 700 z.B. eine Gitternetzstruktur auf mit Netzmaschen 702 um die Aussparung 701 herum auf, deren mittlere Netzmaschendurchmesser zwischen 0.01 bis 6 mm, bevorzugt bei 0.2 bis 0.5 mm liegen können. Die Geometrie der Netzmaschen 702 kann dabei regelmäßig oder unregelmäßig sein.

**Fig. 5d** zeigt beispielhaft ein elektrisches Abschirmelement 800 mit Wabenstruktur um die Aussparung 801 herum, mit mittleren Wabendurchmessern der Wabenröhren 802, die z.B. zwischen 0.01 bis 6 mm, bevorzugt bei 3 bis 4 mm, liegen können. Der Wabenquerschnitt kann dabei wie dargestellt fünfeckig sein, aber es sind auch andere Querschnittsformen möglich, wie regelmäßige Polygonenform, z.B. Dreieck, Quadrat, konvexe und/oder nichtkonvexe Innenwandform, sternförmige Polygonenform, runde Formen, z.B. Kreisform, Ellipsenform, oder eine Kombination genannter Formen.

Bevorzugt sind hexagonale Wabenquerschnittsstrukturen, um unter anderem vorteilhafterweise ein optimales Verhältnis von Wabenröhrenöffnungsquerschnitt zum Wabenröhrenwandungsquerschnitt zu erreichen, und auch z.B. die Wabenstruktur leicht mittels Falt- und Fügetechnischer Verfahren z.B. aus Folienmaterial herstellen zu können.

Es sei angemerkt, dass die beispielhafte kreisrunde Außenkontur des elektrischen Abschirmelementes, bzw. des Absaugventils, eine Konsequenz der Anpassung an die üblicherweise kreisrunde Behältermündungsform ist. Es ist deshalb ohne weiteres möglich, die Geometrie des Absaugventils bzw. des elektrischen Abschirmelements auch an nicht kreisrunde Behälteröffnungen, z.B. rechtwinklige Behälteröffnungen anzupassen.

Es folgen 2 Blatt mit 8 Figuren.

Die verwendeten Bezugszeichen sind dabei wie folgt belegt:
**100, 200, 300** Absaugventil
**101, 203, 204, 205, 302, 500, 600, 700, 800** elektrisches Abschirmelement
**102, 211, 304, 501, 601, 701, 801** Aussparung
**103, 201, 301** Gaslanze
**104, 212, 305** Behälter
**105, 206, 207, 208** Höhe elektrisches Abschirmelement
**209, 210** Abstand zwischen benachbarten elektrischen Abschirmelementen
**106, 202** Höhe Absaugventil
**303** Halterung für Gaslanze und/oder elektrisches Abschirmelement
**306, 802** Wabenröhre
**307, 401** Wabenröhrendurchmesser
**402** Länge Wabenröhre
**403** Wabenstruktur
**502** Poren
**602** konzentrische Wand
**603** radiale Zwischentrennwand
**702** Netzmaschen

## Patentansprüche

1. Vorrichtung zur Beschichtung eines Behälters (104), beispielsweise einer Kunststoffflasche, mittels Plasmabehandlung, beinhaltend wenigstens eine Gaslanze (103) zum Zuführen von Prozessgas in den Behälter (104) und wenigstens ein Absaugventil (100) zum Absaugen von Luft aus dem Behälterinneren, wobei das Absaugventil (100) wenigstens eine Aussparung (102) zur Aufnahme oder Einfuhr der wenigstens einen Gaslanze in den Behälter (104) aufweist, und das Absaugventil (100) wenigstens ein geerdetes elektrisches gasdurchlässiges Abschirmungselement (101) aufweist, und das wenigstens eine geerdete gasdurchlässige elektrische Abschirmungselement (101) das Zünden und/oder Brennen von Plasma im Absaugventil nahezu vollständig verhindert und/oder unterdrückt, **dadurch gekennzeichnet, dass**
das elektrische Abschirmungselement um die wenigstens eine Aussparung zur Aufnahme oder Einfuhr der wenigstens einen Gaslanze eine Wabenstruktur aufweist und wobei die mittlere Länge der Wabenröhren größer als der mittlere Wabendurchmesser der Wabenröhren ist.

2. Vorrichtung nach Anspruch 1, **dadurch gekennzeichnet, dass** die wenigstens eine Aussparung (102) mittig angeordnet ist.

3. Vorrichtung nach einem der vorherigen Ansprüche, wobei die mittleren Wabendurchmesser der Wabenröhren zwischen 0.01 bis 6 mm, bevorzugt 3 bis 4 mm, liegen.

4. Vorrichtung nach einem der vorherigen Ansprüche, wobei die mittlere Länge der Wabenröhren um einen Faktor von 1.5, 2.0, 4.0, 6.0, 10.0 oder mehr, bevorzugt 5 bis 10, größer ist als der Wabendurchmesser der Wabenröhren.

5. Vorrichtung nach einem der vorherigen Ansprüche, **dadurch gekennzeichnet, dass** die Querschnitte der Wabenröhren regelmäßige Polygonenform, z.B. Dreieck, Quadrat, Pentagon, Hexagon, konvexe und/oder nichtkonvexe Innenwandform, sternförmige Polygonenform, runde Formen, z.B. Kreisform, Ellipsenform, oder eine Kombination genannter Formen aufweisen.

6. Vorrichtung nach einem der vorherigen Ansprüche, **dadurch gekennzeichnet, dass;** das elektrische Abschirmungselement aus elektrisch leitfähiger Keramik, z.B. Al₂O₃/TiN, elektrisch leitfähiger Verbundkeramik mit Kohlenstofffasern, aus Metall, z.B. Aluminium, elektrisch leitfähig ausgestattetem Kunststoff, oder aus einer Kombination genannter Materialen besteht.

7. Vorrichtung nach einem der vorigen Ansprüche **dadurch gekennzeichnet, dass** der Strömungswiderstand des Absaugventils beim Absaugen gleich oder kleiner ist als der Strömungswiderstand durch die Behältermündung.

8. Vorrichtung nach einem der vorigen Ansprüche **dadurch gekennzeichnet, dass** das Absaugventil so konfiguriert ist, dass das Behälterinnere in weniger als 500 ms auf einen gewünschten Prozessdruck evakuiert werden kann.

9. Vorrichtung nach einem der vorigen Ansprüche **dadurch gekennzeichnet, dass** das elektrische Abschirmungselement in seiner Höhe mindestens 10 %, 20%, 30% oder 60% oder mehr der Höhe des Absaugventils einnimmt.

10. Verfahren zur Beschichtung eines Behälters, beispielsweise einer Kunststoffflasche, mittels Plasmabehandlung, beinhaltend:
Einführen einer Gaslanze in das Behälterinnere, wobei die Gaslanze durch eine Aussparung in einem auf der Behälteröffnung sitzenden Absaugventils geführt wird oder darin aufgenommen wird.
Absaugen bzw. Evakuierung des Behälterinneren auf Prozessdruck, z.B. 1 bis 30 Pa, Zuführen von Prozessgas in das Behälterinnere durch die Gaslanze,
und plasmaunterstützte Beschichtung des Behälterinneren durch Gasphasenabscheidung, wobei ein sich im Absaugventil befindliches elektrisches Abschirmelement eine Wabenstruktur aufweist wobei die mittlere Länge der Wabenröhren größer als der mittlere Wabendurchmesser der Wabenröhren ist, und das Abschirmelement ein Zünden und/oder Brennen von Plasma im Absaugventil, bzw. in einem Bereich der nicht beschichtet werden soll, nahezu vollständig verhindert oder unterdrückt.

11. Verfahren nach dem vorherigen Anspruch, wobei die mittleren Wabendurchmesser der Wabenröhren zwischen 0.01 bis 6 mm, bevorzugt 3 bis 4 mm, liegen.

## Claims

1. Apparatus for coating a container (104), e.g. a plastic bottle, by means of a plasma treatment, comprising at least one gas lance (103) for supplying process gas into the container (104) and at least one suction valve (100) for sucking off air from the interior of the container, wherein the suction valve (100) has at least one recess (102) for receiving or introducing the at least one gas lance into the container (104), and the suction valve (100) has at least one grounded, gas-permeable, electrical shielding element (101), and the at least one grounded, gas-permeable, electrical shielding element (101) prevents and/or suppresses nearly entirely the ignition and/or burning of plasma in the suction valve,
**characterized in that**
the electrical shielding element around the at least one recess for receiving or introducing the at least one gas lance has a honeycomb structure and wherein the average length of the honeycomb tubes is greater than the average honeycomb diameter of the honeycomb tubes.

2. Apparatus according to claim 1, **characterized in that** the at least one recess (102) is centrally arranged.

3. Apparatus according to one of the preceding claims, wherein the average honeycomb diameters of the honeycomb tubes are ranging between 0.01 and 6 mm, preferably between 3 and 4 mm.

4. Apparatus according to one of the preceding claims, wherein the average length of the honeycomb tubes exceeds the average honeycomb diameter of the honeycomb tubes by a factor of 1.5, 2.0, 4.0, 6.0, 10.0 or more, preferably 5 to 10.

5. Apparatus according to one of the preceding claims, **characterized in that** the cross-sections of the honeycomb tubes have regular polygon shapes, e.g. a triangle, square, pentagon, hexagon, convex and/or non-convex inner wall shape, a star-shaped polygon shape, round shapes, e.g. a circular shape, elliptical shape, or a combination of the aforementioned shapes.

6. Apparatus according to one of the preceding claims, **characterized in that** the electrical shielding element is made of electrically conductive ceramics, e.g. Al₂O₃/TiN, of electrically conductive composite ceramics with carbon fibers, of a metal, e.g. aluminum, of a plastic material having electrically conductive properties, or of a combination of the aforementioned materials.

7. Apparatus according to one of the preceding claims, **characterized in that** the flow resistance of the suction valve when sucking off is equal to or smaller than the flow resistance through the container opening.

8. Apparatus according to one of the preceding claims, **characterized in that** the suction valve is configured to allow the interior of the container to be evacuated to a desired process pressure in less than 500 ms.

9. Apparatus according to one of the preceding claims, **characterized in that** the electrical shielding element covers in respect of its height at least 10%, 20%, 30% or 60% or more of the height of the suction valve.

10. Method for coating a container, e.g. a plastic bottle, by means of a plasma treatment, comprising:
introducing a gas lance into the interior of the container, the gas lance being passed through or received in a recess in a suction valve sitting on the container opening,
evacuating the interior of the container to a process pressure, for instance, of 1 to 30 Pa,
supplying process gas into the interior of the container by the gas lance,
and plasma-enhanced coating of the interior of the container by chemical vapor deposition, wherein an electrical shielding element in the suction valve has a honeycomb structure wherein the average length of the honeycomb tubes is greater than the average honeycomb diameter of the honeycomb tubes, and wherein the electrical shielding element prevents and/or suppresses nearly entirely the ignition and/or burning of plasma in the suction valve or in a region not to be coated.

11. Method according to the preceding claim, wherein the average honeycomb diameters of the honeycomb tubes are ranging between 0.01 and 6 mm, preferably between 3 and 4 mm.

## Revendications

1. Dispositif de revêtement d'un récipient (104), par exemple d'une bouteille en plastique, par traitement au plasma, contenant au moins une lance à gaz (103) pour acheminer un gaz de processus dans le récipient (104), et au moins une soupape d'aspiration (100) pour aspirer de l'air hors de l'intérieur du récipient, la soupape d'aspiration (100) présentant au moins un évidement (102) pour recevoir ou introduire l'au moins une lance à gaz dans le récipient (104), et la soupape d'aspiration (100) présentant au moins un élément de blindage électrique (101) perméable au gaz et mis à la terre et l'au moins un élément de blindage électrique (101) perméable au gaz et mis à la terre empêchant presque complètement et/ou supprimant l'allumage et/ou la combustion de plasma dans la soupape d'aspiration, **caractérisé en ce que**
l'élément de blindage électrique présente autour de l'au moins un évidement, pour recevoir ou introduire l'au moins une lance à gaz, une structure en nid d'abeilles et la longueur moyenne des tubes du nid d'abeilles étant supérieure au diamètre moyen de nid d'abeilles des tubes du nid d'abeilles.

2. Dispositif selon la revendication 1, **caractérisé en ce que** l'au moins un évidement (102) est disposé centralement.

3. Dispositif selon l'une quelconque des revendications précédentes, dans lequel les diamètres moyens de nid d'abeilles des tubes du nid d'abeilles sont compris entre 0,01 et 6 mm, de préférence entre 3 et 4 mm.

4. Dispositif selon l'une quelconque des revendications précédentes, dans lequel la longueur moyenne des tubes du nid d'abeilles est supérieure d'un facteur de 1,5, 2,0, 4,0, 6,0, 10,0 ou plus, de préférence de 5 à 10, au diamètre de nid d'abeilles des tubes du nid d'abeilles.

5. Dispositif selon l'une quelconque des revendications précédentes, **caractérisé en ce que** les sections transversales des tubes du nid d'abeilles présentent une forme de polygone régulier, par exemple un triangle, un quadrilatère, un pentagone, un hexagone, une forme de paroi intérieure convexe et/ou non convexe, une forme de polygone stellaire, des formes rondes, par exemple une forme circulaire, une forme en ellipse ou une combinaisons desdites formes.

6. Dispositif selon l'une quelconque des revendications précédentes, **caractérisé en ce que** l'élément de blindage électrique se compose de céramique électriquement conductrice, par exemple de Al₂O₃/TiN, de céramique composite électriquement conductrice avec des fibres de carbone, de métal, par exemple d'aluminium, de plastique équipé de manière électriquement conductrice, ou d'une combinaison desdits matériaux.

7. Dispositif selon l'une quelconque des revendications précédentes, **caractérisé en ce que** la résistance à l'écoulement de la soupape d'aspiration lors de l'aspiration est inférieure ou égale à la résistance à l'écoulement à travers l'embouchure du récipient.

8. Dispositif selon l'une quelconque des revendications précédentes, **caractérisé en ce que** la soupape d'aspiration est configurée de telle sorte que l'intérieur du récipient puisse être évacué en moins de 500 ms à une pression de processus souhaitée.

9. Dispositif selon l'une quelconque des revendications précédentes, **caractérisé en ce que** l'élément de blindage électrique constitue, en termes de hauteur, au moins 10 %, 20 %, 30 % ou 60 % ou plus de la hauteur de la soupape d'aspiration.

10. Procédé de revêtement d'un récipient, par exemple d'une bouteille en plastique, par traitement au plasma, comprenant les étapes suivantes :
introduction d'une lance à gaz à l'intérieur du récipient, la lance à gaz étant guidée à travers un évidement dans une soupape d'aspiration reposant sur l'ouverture du récipient, ou étant reçue dans celui-ci,
aspiration ou évacuation de l'intérieur du récipient à la pression de processus, par exemple de 1 à 30 Pa,
alimentation de gaz de processus à l'intérieur du récipient à travers la lance à gaz, et
revêtement assisté par plasma de l'intérieur du récipient par dépôt en phase gazeuse, un élément de blindage électrique, se trouvant dans la soupape d'aspiration, présentant une structure en nid d'abeilles, la longueur moyenne des tubes du nid d'abeilles étant supérieure au diamètre moyen de nid d'abeilles des tubes du nid d'abeilles, et l'élément de blindage empêchant presque complètement ou supprimant un allumage et/ou une combustion de plasma dans la soupape d'aspiration, ou dans une région qui ne doit pas être revêtue.

11. Procédé selon la revendication précédente, dans lequel les diamètres moyens de nid d'abeilles des tubes du nid d'abeilles sont situés entre 0,01 et 6 mm, de préférence entre 3 et 4 mm.
